(19) Europäisches Patentamt
European Patent Office
Office européen des brevets

(11) **EP 2 883 110 B1**

(12) **FASCICULE DE BREVET EUROPEEN**

(45) Date de publication et mention de la délivrance du brevet:
**25.05.2016 Bulletin 2016/21**

(51) Int Cl.:
*G03F 7/40* *(2006.01)*      *G03F 7/09* *(2006.01)*
*G03F 7/11* *(2006.01)*      *G03F 7/20* *(2006.01)*

(21) Numéro de dépôt: **13745079.7**

(22) Date de dépôt: **02.08.2013**

(86) Numéro de dépôt international:
**PCT/EP2013/066311**

(87) Numéro de publication internationale:
**WO 2014/023665 (13.02.2014 Gazette 2014/07)**

(54) **SUBSTRAT POUR LITHOGRAPHIE ELECTRONIQUE A HAUTE RESOLUTION ET PROCEDE DE LITHOGRAPHIE CORRESPONDANT**

SUBSTRAT FÜR HOCHAUFLÖSENDE ELEKTRONISCHE LITHOGRAFIE UND ENTSPRECHENDES LITHOGRAFIEVERFAHREN

SUBSTRATE FOR HIGH-RESOLUTION ELECTRONIC LITHOGRAPHY AND CORRESPONDING LITHOGRAPHY METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.08.2012 FR 1257711**

(43) Date de publication de la demande:
**17.06.2015 Bulletin 2015/25**

(73) Titulaire: **Commissariat à l'Énergie Atomique et aux Énergies Alternatives
75015 Paris (FR)**

(72) Inventeurs:
• **IMBERT, Jean-Louis
  F-38170 Seyssinet (FR)**
• **CONSTANCIAS, Christophe
  F-38700 Sarcenas (FR)**

(74) Mandataire: **Bréda, Jean-Marc et al
Marks & Clerk France
Conseils en Propriété Industrielle
Immeuble " Visium "
22, avenue Aristide Briand
94117 Arcueil Cedex (FR)**

(56) Documents cités:
**WO-A1-2005/114332      JP-A- 2004 119 414**

• **KAZUHIRO SHIMIZU ET AL: "NANOMETER PATTERNING BY ELECTRON BEAM LITHOGRAPHY USING AN AMORPHOUS CARBON FILM AS AN INTERMEDIATE LAYER", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 30, no. 4 PART 01, 30 avril 1991 (1991-04-30), pages 890-891, XP000263007, ISSN: 0021-4922, DOI: 10.1143/JJAP.30.890**
• **KOSKINEN J ET AL: "Porosity of thin diamond-like carbon films deposited by an arc discharge method", SURFACE AND COATINGS TECHNOLOGY, ELSEVIER, AMSTERDAM, NL, vol. 62, no. 1-3, 10 décembre 1993 (1993-12-10), pages 356-360, XP024500244, ISSN: 0257-8972, DOI: 10.1016/0257-8972(93)90267-R [extrait le 1993-12-10]**

EP 2 883 110 B1

**Description**

L'invention concerne la lithographie par faisceau d'électrons.

On sait que la lithographie par faisceau d'électrons permet d'écrire ou transférer des motifs de très petites dimensions et extrêmement denses, qu'il n'est pas possible de réaliser avec la photolithographie en lumière visible ou même en ultraviolet à cause des phénomènes de diffraction. La limite de résolution en photolithographie reste de l'ordre de la longueur d'onde de la lumière utilisée. La limite de résolution en lithographie par faisceau d'électrons peut s'approcher de 10 nanomètres ou même moins, c'est-à-dire qu'on doit théoriquement pouvoir tracer des motifs comportant des traits de largeur et d'espacement pouvant descendre à 10 nanomètres, ou même au-dessous.

De telles résolutions peuvent être utiles notamment pour la réalisation d'éléments d'optique diffractive en ultraviolet ou en rayons X. Ces éléments d'optique diffractive peuvent être des réseaux de diffraction, des lentilles de Fresnel ou d'autres éléments tels que des réseaux dits "blazés" (de l'anglais "blazed grating") qui sont des motifs de gravure régulière en dents de scie destinés à améliorer le rendement de diffraction de la surface gravée. D'autres applications sont envisageables, par exemple pour la réalisation de masques de fabrication de nanostructures microélectroniques très denses ou pour l'écriture directe de ces nanostructures.

Pour obtenir une grande résolution, il faut partir d'un faisceau électronique de très faible diamètre qui bombarde localement la surface d'un matériau sensible à l'énergie apportée par les électrons, matériau qu'on appellera ci-après matériau électro-sensible. L'exposition se fait par balayage de la surface et allumage ou interruption du faisceau en fonction du motif à exposer.

Le faisceau d'électrons est focalisé sur la surface à l'aide de lentilles électromagnétiques, et ces lentilles produisent des aberrations optiques qui sont d'autant plus faibles que la vitesse des électrons est plus grande, et donc que l'énergie du faisceau est plus élevée. D'autre part, le faisceau d'électrons tend à se disperser (et donc à s'élargir) en raison de la répulsion mutuelle qu'exercent entre eux les électrons, mais cette dispersion est plus faible lorsque la vitesse des électrons est plus élevée. On ne sait pas faire des faisceaux de très faible diamètre (inférieur à 5 nanomètres) à des énergies inférieures à 30 keV. Pour obtenir un faisceau de ce diamètre, nécessaire à l'augmentation de la résolution, il faut travailler à plus grande énergie. Des faisceaux de diamètre 3 nanomètres à distribution d'énergie gaussienne peuvent être produits avec des énergies de 100 keV.

Mais il ne suffit pas d'avoir un faisceau de très faible diamètre pour obtenir une très haute résolution. En effet, même si la taille du faisceau est optimisée, deux effets contribuent à limiter la résolution des motifs inscrits dans le matériau électro-sensible. Le premier est la dispersion des électrons dans le matériau à l'endroit d'un impact du faisceau : les électrons perdent leur énergie sur des trajectoires aléatoires à partir de leur entrée dans le matériau, et ces trajectoires sont d'autant plus longues que l'énergie est plus importante. La dispersion des électrons sur ces trajectoires aléatoires est une cause d'élargissement du motif à l'endroit de l'impact, causant l'exposition du matériau sensible sur une surface plus large que celle qui serait souhaitée. Le deuxième effet est la rétrodiffusion d'électrons vers des emplacements de couche électro-sensible correspondant à des motifs voisins ; ces électrons rétrodiffusés sont soit des électrons non absorbés par la couche électro-sensible et renvoyés vers elle par des couches sous-jacentes, soit des électrons secondaires arrachés par les premiers aux couches sous-jacentes et rétrodiffusés vers la couche électro-sensible ; ces électrons viennent soit exposer des zones entre les motifs, réduisant ainsi le contraste, soit s'ajouter aux électrons du faisceau direct qui doivent exposer les motifs voisins, et cela peut modifier, comme on l'expliquera plus loin, la définition précise des motifs voisins.

L'influence des électrons rétrodiffusés s'observe principalement sur les motifs les plus denses, c'est-à-dire des motifs dans lesquels des zones exposées, séparées par des zones non exposées, sont très proches les unes des autres. Dans un réseau de lignes très serrées, non seulement les intervalles entre lignes exposées reçoivent une dose indésirable, mais les lignes exposées elles-mêmes, y compris celles situées jusqu'à plusieurs dizaines de micromètres de distance, peuvent recevoir un excédent de dose lié aux électrons rétrodiffusés pendant l'exposition de lignes voisines ; cet excédent de dose tend à modifier (augmenter dans le cas d'une résine positive) la largeur des lignes par rapport à la largeur qu'aurait une ligne éloignée de toute autre zone exposée. En particulier, les lignes situées au centre d'un réseau recevront un excédent de dose par rapport aux lignes au bord du réseau, aboutissant à une largeur de ligne supérieure dans le centre et inférieure sur les bords. Il en résulte une perte de contraste et une difficulté à maîtriser l'uniformité de largeur des traits dans toute la surface du motif.

On a déjà proposé des solutions tendant à compenser les effets dus à la rétrodiffusion des électrons. Ces solutions peuvent consister à moduler les doses selon les régions à exposer (voir Journal of vacuum science and technology B Vol 11 n°6, pp 2741-2745, Novembre 1993, "PROXECCO - Proximity effect correction by convolution", EISENMANN H. ; WAAS T. ; HARTMANN H. ) ; ou encore à corriger à l'avance la géométrie des motifs à exposer (voir Japanese journal of Applied Physics vol 37, n°12B, pp 6774-6778, 1998, A New Approach of E-beam Proximity Effect Correction for High-resolution Applications, SIMECEK M. ; ROSENBUSCH A. ; OHTA T. ; JINBO H.) ; ou encore à corriger par la méthode dite " de Ghost" utilisant un masque de soustraction de l'erreur liée aux variations de densité de lignes (voir Journal of vacuum science and technology B Vol 17 n °6, pp 2860-2863, Novembre 1999, "Proximity effect correction by the GHOST method using a scattering stencil mask", YAMASHITA H. et autres).

Ces méthodes sont mathématiquement complexes et imparfaites. Elles dépendent de la géométrie des motifs à réaliser, de l'énergie du faisceau incident, de la nature des matériaux présents dans la cible à exposer.

Le substrat qui supporte la couche électro-sensible faisant l'objet de l'opération de lithographie électronique, participe à la production d'électrons rétrodiffusés. C'est le cas pour les substrats en silicium (fréquemment utilisés pour des dispositifs électroniques) ou en verre (fréquemment utilisés pour réaliser des masques de photolithographie). On a donc également proposé d'amincir le substrat dans la zone lithographiée, ce qui limite en partie la rétrodiffusion.

On a proposé également d'utiliser sous la couche électro-sensible une fine couche de carbone amorphe d'une centaine de nanomètres d'épaisseur (article Nanometer Patterning by Electron Beam Lithography Using an Amorphous Carbon Film as an Intermediate Layer, dans Japanese Journal of Applied Physics, Vol 30, N°4, April 1991, pp 890-891). Les résultats ne sont pas suffisants en particulier pour les hautes énergies de faisceau incident.

On propose selon l'invention de former entre le substrat et la couche électro-sensible une couche intermédiaire en matériau poreux, donc de densité réduite d'au moins deux fois par rapport au même matériau non poreux, ce matériau ayant une faible masse atomique, inférieure à 32 et de préférence inférieure à 20. La couche poreuse est de préférence en silicium poreux (masse atomique 14) ou en carbone poreux (masse atomique 6) et dans ce dernier cas en nanotubes de carbone (assimilable à un matériau poreux du fait de sa densité réduite). Par sa faible densité et sa faible masse atomique, cette couche poreuse réduit la production d'électrons rétrodiffusés et surtout les diffuse de manière plus dispersée, ce qui perturbe moins les motifs adjacents. La densité du matériau, et en particulier du silicium ou du carbone, est d'au moins deux fois plus faible que la densité du même matériau non poreux (silicium monocristallin par exemple ou carbone déposé à la tournette par exemple) ; la couche poreuse a ainsi une densité de préférence inférieure à 1,5, voire inférieure à 1 ou même 0,5. Par comparaison, le silicium non poreux a une densité autour de 2,5 et le carbone amorphe non poreux a une densité comprise entre 1,8 et 2,1. La densité du matériau poreux est de préférence comprise entre 0,1 et 0,5 fois la densité du matériau non poreux pour du silicium, et peut même être encore plus faible pour des nanotubes de carbone (la densité d'une couche de nanotubes de carbone peut descendre jusqu'à 0,1 voire moins, soit environ 20 fois moins que la densité du carbone non poreux). La porosité est liée à la présence d'espaces dépourvus de matière entre des zones de matière, c'est-à-dire entre des zones regroupant des atomes du matériau considéré.

L'invention propose donc une structure de support portant une couche mince de matériau à traiter sélectivement selon un motif de haute résolution, et destinée à recevoir en outre une couche de matériau électrosensible pour définir le motif, la structure de support comprenant la superposition d'un substrat et d'une couche de matériau poreux comme indiqué au paragraphe précédent.

Par couche de matériau à traiter on entend une couche semiconductrice ou isolante ou conductrice sur laquelle on veut faire un traitement localisé selon un motif bien défini de haute résolution ; ce traitement peut être notamment une gravure de la couche ou une implantation d'impuretés dans une couche semiconductrice, ou une oxydation localisée de la couche, etc.

La couche de matériau électro-sensible est déposée, sauf cas particulier, au-dessus de la couche de matériau à traiter ; toutefois, dans le cas d'un traitement par une opération connue sous le nom de lift-off, la couche de matériau à traiter serait déposée après exposition et développement de la couche de matériau électro-sensible.

La couche de matériau électro-sensible peut-être une résine dont les propriétés (par exemple le degré de polymérisation) sont modifiées par le faisceau électronique qui la bombarde ; elle est exposée au faisceau électronique qui balaye toute la surface selon le motif souhaité, puis elle est développée pour éliminer les parties exposées et garder les autres (dans le cas où il s'agit d'une résine positive) ou au contraire éliminer les parties non exposées et garder les parties exposées (dans le cas d'une résine négative).

La structure de support peut comporter en outre une couche isolante, notamment en oxyde de silicium, servant de tampon entre la couche poreuse et la couche à traiter, ou de tampon entre la couche poreuse et une superposition de couches parmi lesquelles la couche de matériau à traiter et la couche de matériau électro-sensible.

La couche de matériau à traiter peut être du silicium monocristallin, le traitement pouvant être une implantation localisée d'impuretés de dopage selon un motif défini à partir du motif d'exposition au faisceau électronique. La couche de matériau à traiter peut aussi être une couche métallique ou isolante ou semiconductrice déposée notamment :

- au-dessus de la couche intermédiaire poreuse,
- ou au-dessus d'une couche de silicium monocristallin elle-même mise en place au-dessus de la couche intermédiaire poreuse.

En pratique, notamment dans le cas de la fabrication d'un circuit électronique sur silicium, on constituera la structure de support à partir d'un premier substrat recouvert sur sa face avant de la couche poreuse ; puis on reportera sur la face avant du premier substrat (avec ou sans matière de collage) un deuxième substrat. Le deuxième substrat est de préférence un substrat de silicium monocristallin revêtu d'une couche isolante superficielle (de préférence de l'oxyde de silicium) venant s'appliquer contre la face avant du premier substrat. Le deuxième substrat est ensuite aminci (par usinage ou par fracture thermique et/ou mécanique au niveau d'une zone fragile enterrée, obtenue par exemple par implantation) pour ne conserver qu'une couche de silicium monocristallin d'épaisseur inférieure à 100 nanomètres d'épaisseur. C'est cette couche qui constituera la couche à traiter ou qui sera recouverte directement ou indirectement d'une couche à traiter.

La couche poreuse de densité réduite a une épaisseur qui est de préférence au moins égale à la longueur de diffusion moyenne (en anglais : "mean free path") des électrons dans le matériau de la couche pour l'énergie du faisceau d'exposition considéré. Pour des énergies d'environ 100keV, la longueur de diffusion est de quelques dizaines de micromètres dans le silicium ou le carbone et l'épaisseur de couche poreuse est de préférence d'au moins 20 micromètres, de préférence au moins 50 micromètres et en particulier entre 50 et 100 micromètres, pour ces deux matériaux.

La couche poreuse intermédiaire pourrait être constituée par un matériau composé plutôt qu'un matériau élémentaire, pourvu que ce matériau composé ait une masse atomique moyenne respectant les critères indiqués plus haut. L'alumine $Al_2O_3$ pourrait être envisagée. Le carbure de lithium également, de masse atomique moyenne particulièrement faible. Mais les matériaux préférés restent le silicium poreux et le carbone poreux sous forme de nanotubes du fait de leurs très bonnes possibilités actuelles de traitement industriel. La masse atomique, ou masse atomique moyenne, dans le cas d'une molécule composée de plusieurs atomes est ici définie comme étant la somme des masses atomiques des atomes de la molécule, divisée par le nombre d'atomes de la molécule.

Outre une structure de support pour une couche à traiter, l'invention concerne un procédé de lithographie électronique comprenant la formation d'une structure de support comportant un substrat recouvert d'une couche poreuse d'un matériau ayant une densité inférieure à la moitié de la densité du même matériau non poreux et ayant une masse atomique inférieure à 20, la mise en place au-dessus de la couche poreuse d'une couche de matériau à traiter sélectivement selon un motif de haute résolution, la mise en place d'une couche de matériau sensible à un faisceau électronique, et l'exposition de la couche de matériau sensible à un faisceau électronique de haute énergie pour définir le motif dans cette dernière couche, puis une opération de traitement, par implantation et/ou gravure, de la couche de matériau à traiter sélectivement.

D'autres caractéristiques et avantages de l'invention apparaîtront à la lecture de la description détaillée qui suit et qui est faite en référence aux dessins annexés dans lesquels :

- la figure 1 représente schématiquement un motif dense en réseau de lignes à inscrire dans une couche sensible ;
- la figure 2 représente une courbe montrant le profil d'énergie déposée par les électrons lors de l'exposition du réseau ;
- la figure 3 représente l'effet qui en résulte dans le motif réellement inscrit dans la couche sensible ;
- la figure 4 représente une structure de support selon l'invention dans un cas simple, avec une couche intermédiaire de silicium poreux ;
- la figure 5 représente une structure de support selon l'invention dans un cas simple, avec une couche intermédiaire de nanotubes de carbone ;
- la figure 6 représente une structure de support dans le cas de la fabrication d'un circuit électronique utilisant une couche mince de silicium monocristallin ;
- la figure 7 représente une structure analogue avec du carbone poreux ;
- la figure 8 représente la répartition d'énergie d'électrons rétrodiffusés autour d'un point d'impact du faisceau électronique en fonction de la distance au point d'impact.

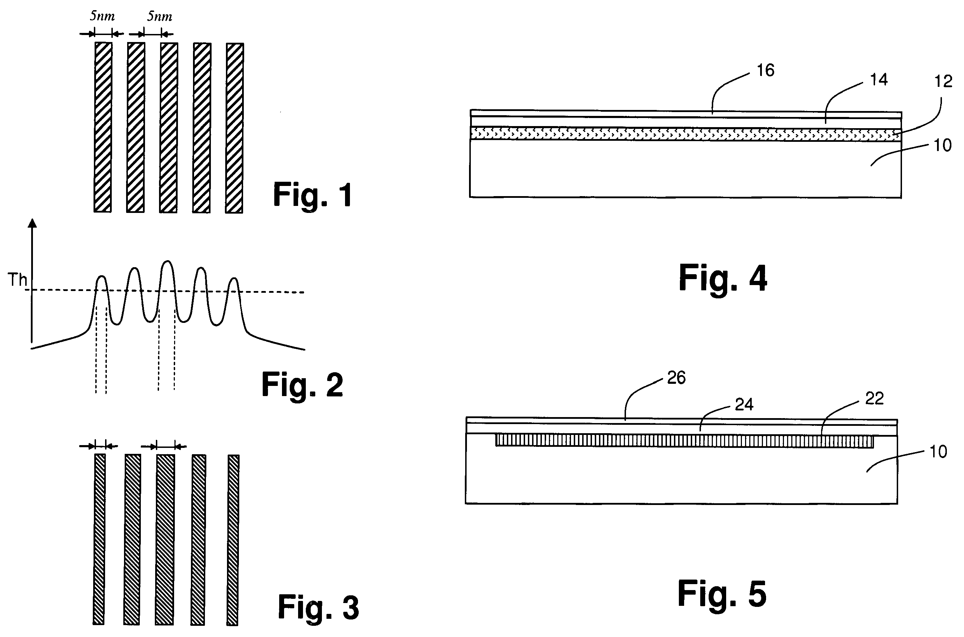

Sur la figure 1, on a représenté un motif régulier, dense, de lignes qu'on souhaite inscrire dans une couche sensible aux électrons ou couche électro-sensible déposée sur un substrat. Le motif comprend à titre d'exemple des lignes de 5 nanomètres de largeur espacées d'intervalles de 5 nanomètres.

Le faisceau d'électrons qui est utilisé pour exposer la couche sensible a un diamètre inférieur à 5 nanomètres, et pour cela il a une très haute énergie, de préférence de 30 à 100keV ou plus ; du fait de cette haute énergie, des électrons sont rétrodiffusés dans le substrat qui porte la couche sensible, et ces électrons peuvent venir exposer la couche sensible en dehors de l'endroit d'impact du faisceau, soit entre les lignes à exposer soit sur des lignes voisines de l'impact du faisceau. De la rétrodiffusion d'électrons vers les intervalles entre les lignes il résulte un risque d'exposition partielle de la couche sensible là où elle ne devrait pas être exposée. De la rétrodiffusion d'électrons vers les lignes voisines il résulte un risque de surexposition des lignes voisines qui reçoivent (ou ont reçu précédemment ou recevront ultérieurement) un impact volontaire du faisceau d'électrons de haute énergie lors du balayage de la surface par le faisceau.

La figure 2 illustre schématiquement, en unités arbitraires, l'énergie reçue par la couche sensible au niveau de chacune des différentes lignes du réseau, dans une configuration où on tient compte de l'énergie en provenance des électrons rétrodiffusés. Une ligne au centre du réseau reçoit plus d'énergie (pour une même énergie de faisceau direct) que les lignes situées au bord du réseau. De même, une ligne dans un réseau dense reçoit plus d'énergie qu'une ligne dans un réseau moins dense.

Si on simplifie le comportement de la couche sensible, on peut considérer que la couche sensible est exposée au-delà d'un seuil d'énergie reçue et n'est pas exposée au dessous de ce seuil. Le seuil est représenté par une ligne de niveau Th sur la courbe de la figure 2. Comme la distribution d'énergie dans chaque ligne est de forme gaussienne, on voit que la largeur de la zone effectivement exposée dépend de l'énergie globalement reçue, et cette largeur varie donc selon que la ligne exposée est dans une région de motif dense (avec influence des électrons rétrodiffusés) ou dans une région de motif moins dense (sans influence des électrons rétrodiffusés). L'influence des électrons rétrodiffusés peut s'étendre sur plusieurs dizaines de micromètres, ce qui veut dire, pour des lignes à un pas de 10 nanomètres, que cette influence peut s'étendre sur plusieurs centaines de lignes voisines, de sorte qu'une ligne donnée reçoit des électrons rétrodiffusés par l'exposition de plusieurs centaines d'autres lignes. Même si la quantité d'électrons reçue de cette manière est à chaque fois faible, son cumul est important.

Il en résulte, comme représenté sur la figure 3, un motif de lignes réellement exposées qui présentent une non uniformité de largeur de lignes, la non uniformité étant liée en particulier à la densité des motifs inscrits. Les lignes au centre d'un réseau dense reçoivent une dose d'électrons plus importante que les lignes sur les bords du réseau ou que des lignes isolées ou faisant partie d'un réseau peu dense.

Ces phénomènes peuvent être modélisés à partir d'équations telles que l'équation de Bethe qui représentent la perte d'énergie (-dE) d'un faisceau d'électrons le long d'un parcours élémentaire (dS) à travers une couche de matériau ; cette perte d'énergie se traduit par différents processus tels que l'émission d'électrons secondaires, le freinage continu (appelé encore "émission Bremsstrahlung"), l'excitation plasmon :

$$-\frac{dE}{dS} = \frac{4\pi NZ}{(4\pi\varepsilon_0)^2}.\frac{e^4}{2E_0}\ln\left(\frac{4E_0}{I}\right)^{1/2}$$

$\varepsilon_0$ est la permittivité du vide,
e est la charge de l'électron,
N est le nombre d'atomes par unité de volume ; ce nombre est lié à la densité du matériau, plus grande si N est plus grand, plus petite si N est plus petit,
Z est le numéro atomique du matériau,
$E_0$ est l'énergie des électrons incidents, qui est typiquement de 50 keV à 150 keV pour des faisceaux de 2 à 4 nanomètres de diamètre,
I est l'énergie moyenne d'ionisation du matériau dans lequel se propagent les électrons ; elle dépend du numéro atomique et elle est définie de manière empirique ; une valeur donnée dans la littérature est parfois, en electron-volts, $I = (9,76 + 58,8 \times Z^{1,19})$ pour

Z supérieur ou égal à 13, ou parfois une expression simplifiée $I = 11,5 \times Z$.

De cette équation on tire l'information que la longueur de diffusion $S_{diff}$ varie proportionnellement au carré de l'énergie $E_0$ du faisceau incident. La longueur de diffusion ( en anglais : "mean free path") est la distance parcourue aboutissant à une perte d'énergie de 50% des électrons.

Le tableau suivant donne une estimation de la longueur de diffusion $S_{diff}$ en fonction de l'énergie incidente $E_0$ pour le silicium :

| Energie $E_0$ (keV) | 5 | 50 | 95 | 150 |
|---|---|---|---|---|
| $S_{diff}$ (µm) | 0,13 | 8 | 22 | 45 |

De l'équation de Bethe, on tire en outre l'enseignement que la dose parasite d'électrons rétrodiffusés, qui va venir inutilement exposer la couche électro-sensible est sensiblement proportionnelle à la densité (par l'intermédiaire de N) et au numéro atomique, et sensiblement inversement proportionnelle à l'énergie incidente $E_0$.

Selon l'invention, la couche électro-sensible à exposer par lithographie n'est pas déposée directement sur un substrat de silicium ou un substrat de verre, mais elle est déposée sur une couche intermédiaire poreuse, c'est-à-dire une couche de matériau de densité réduite, de faible masse atomique (inférieure à 32 et de préférence inférieure à 20). Les matériaux préférés selon l'invention sont du silicium poreux (numéro atomique 14) ou du carbone sous forme de nanotubes (numéro atomique 6) assimilable à une couche poreuse du fait de sa densité très réduite. La porosité de cette couche réduit le nombre N, réduisant d'autant la perte d'énergie donc les électrons rétrodiffusés. La densité de la couche intermédiaire est au moins deux fois plus faible que la densité du même matériau non poreux (matériau amorphe s'il s'agit du carbone).

De préférence, l'épaisseur de cette couche intermédiaire est supérieure ou égale à la longueur de diffusion $S_{diff}$ pour l'énergie d'exposition $E_0$ envisagée, par exemple supérieure à 20 micromètres pour une centaine de keV.

La figure 4 représente une structure de support selon l'invention dans le cas le plus simple : la structure de support comprend la superposition d'un substrat 10 de silicium ou de verre, et d'une couche 12 de silicium poreux.

Sur cette structure est déposée dans ce cas une couche 14 de matériau à traiter (par implantation ou gravure ou oxydation par exemple). Cette couche peut être par exemple en silicium monocristallin, ou en métal, par exemple en chrome. C'est une couche très mince (moins de cent nanomètres d'épaisseur) qui n'engendre pas elle-même ou très peu de rétrodiffusion d'électrons du fait de sa très faible épaisseur.

Enfin, sur la couche 14 est déposée une couche 16 en matériau sensible à un faisceau électronique, par exemple une résine de type PMMA (polymethyl metacrylate).

La couche de silicium poreux a une densité comprise de préférence entre 10% et 50% de la densité normale du silicium monocristallin massif (ou silicium "bulk") ; elle a une épaisseur d'au moins 50 micromètres, et de préférence d'environ 80 micromètres. Ces valeurs sont bien appropriées pour des énergies de faisceau électronique d'environ 100 keV.

La formation du silicium poreux est une opération à faible coût. Elle peut consister à effectuer une anodisation électrochimique à partir de la surface de silicium monocristallin du substrat. Le substrat est placé entre deux électrodes dans un bain de HF-éthanol. Une différence de potentiel est appliquée entre les électrodes. Les ions fluor F⁻ du bain sont attirés vers le substrat et réagissent avec le silicium pour former des pores. Une fois les premiers pores formés, l'attaque du silicium par HF a lieu préférentiellement au fond des pores et conduit à la formation de silicium poreux.

Le silicium poreux peut éventuellement être dopé.

Dans une autre réalisation schématisée à la figure 5, la couche intermédiaire de densité réduite formée sur le substrat 10 est une couche de nanotubes de carbone 22. Sa porosité peut être très forte puisqu'on sait déposer par exemple des nanotubes de diamètre 5 nanomètres et d'épaisseur de paroi de 1 nanomètre en nombre pouvant être de l'ordre de $5.10^{11}$ par cm$^2$. Cela donne une densité qui est de 3 à 4 % de la densité du carbone massif (amorphe, déposé à la tournette, encore appelé "spin-on-carbon"). Cette densité peut ainsi atteindre 0,1, voire moins. On peut aussi utiliser des nanotubes à parois multiples dont le diamètre à la base est plutôt de l'ordre de 100 nanomètres.

Pour le carbone de faible densité comme pour le silicium de faible densité, l'épaisseur sera de préférence supérieure à la longueur de diffusion des électrons pour l'énergie du faisceau électronique incident. De préférence l'épaisseur de la couche de nanotubes de carbone est d'au moins 50 micromètres, et de préférence d'environ 80 micromètres.

Il est souhaitable de prévoir que la couche de nanotubes de carbone est confinée latéralement, en raison de sa fragilité, de manière qu'elle puisse ensuite supporter le dépôt d'autres couches ou d'autres traitements. La couche 12 peut être déposée à cet effet dans un ou plusieurs compartiments. Les compartiments peuvent être formés par des renfoncements dans le substrat 10, ou bien par la surface du substrat entourée par un cadre de silicium rapporté sur le substrat.

Sur la couche 12 ainsi maintenue, on dépose une couche de matériau à traiter 24 et une couche de matériau électro-sensible 26. On peut également déposer, avant la couche de matériau à traiter et la couche de matériau électro-sensible, une couche de protection qui peut être en carbone, ou oxyde ou nitrure de silicium, ou graphène (monocouche de carbone cristallin).

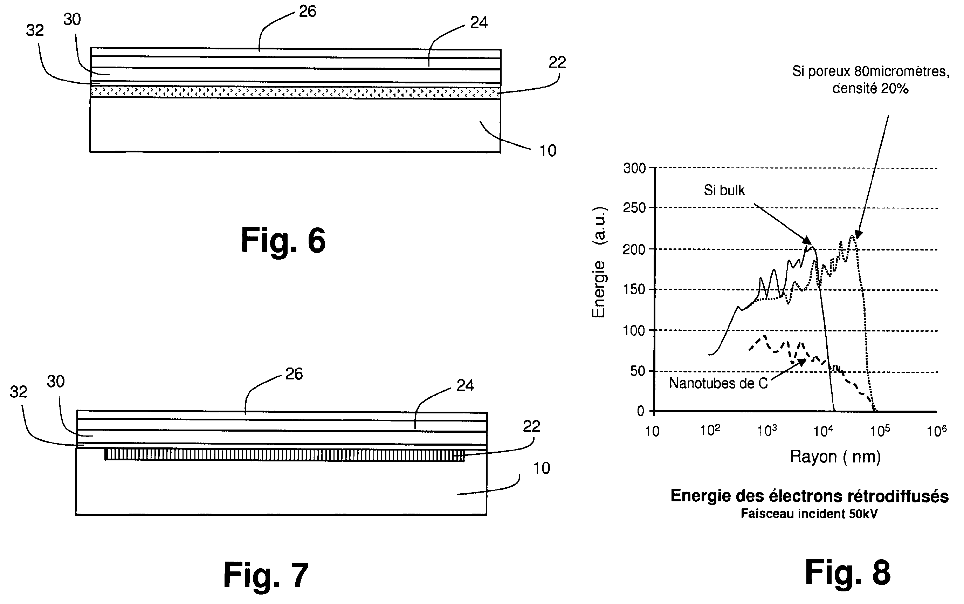

Dans une fabrication destinée à la microélectronique, on pourra prévoir que la structure de support est constituée comme représentée à la figure 6. Elle est fabriquée par report d'un deuxième substrat contre un premier substrat. Le premier substrat 10 est par exemple un substrat de silicium ; il est recouvert sur sa face avant de la couche poreuse 22 (formée par exemple par anodisation électrochimique du substrat). Puis une deuxième substrat 30, en silicium monocristallin ou recouvert d'une couche de silicium monocristallin est reporté contre la couche poreuse. Une couche d'oxyde de silicium 32 est de préférence formée sur le deuxième substrat avant l'opération de report.

Le report est fait de préférence sans matière de collage (c'est un collage direct (encore appelé collage par adhérence moléculaire) entre deux surfaces très planes et très peu rugueuses. Ce deuxième substrat est éliminé dans sa plus grande épaisseur jusqu'à ne garder qu'une couche de silicium monocristallin très mince de quelques dizaines de nanomètres. En raison de cette faible épaisseur, elle n'engendre pas significativement de rétrodiffusion d'électrons lors de l'impact du faisceau de haute énergie. Cette couche de silicium sera la couche de matériau à traiter ou sera recouverte d'une couche mince de matériau à traiter 24, elle-même recouverte du matériau électro-sensible 26.

La figure 7 schématise une structure analogue et fabriquée de la même manière dans le cas où la couche poreuse 22 est une couche de nanotubes de carbone confinée dans des renfoncements de la surface du substrat 10.

On a pu constater, par des logiciels de simulation de trajectoires d'électrons tels que Sceleton ou Casino (couramment utilisés en lithographie électronique), le comportement des électrons rétrodiffusés dans ce cas. On observe qu'à basse énergie (de l'ordre de 5 keV), l'ajout d'une couche mince de carbone réduit beaucoup l'énergie rétrodiffusée ; mais à haute énergie (de l'ordre de 50 keV ou plus) une telle couche n'a pas d'effet pour une épaisseur supérieure à la longueur de diffusion des électrons (typiquement supérieure à 8 micromètres à 50 keV).

Cependant, à haute énergie, une couche de silicium poreux ou de carbone poreux en nanotubes produit un effet de redistribution des zones d'impact des électrons rétro-diffusés. Plus précisément les électrons rétrodiffusés sont dispersés dans un rayon beaucoup plus grand que si la couche électro-sensible était déposée directement ou très proche du substrat de silicium massif ou de verre. De ce fait, l'impact des électrons rétro-diffusés sur les autres éléments du motif à exposer est considérablement plus faible si l'épaisseur de la couche poreuse est suffisante (en pratique : au moins 20 micromètres pour des énergies de plus de 50 keV).

La figure 8 représente, en unités arbitraires, l'énergie des électrons rétrodiffusés en fonction de la distance par rapport au point d'impact du faisceau (exprimée en nanomètres),

- dans le cas où la structure de support est un simple substrat de silicium massif (Sibulk, courbe en traits pleins)
- dans le cas où la structure de support est en silicium massif recouvert d'une couche intermédiaire de silicium poreux de densité cinq fois plus faible et d'épaisseur 80 micromètres : courbe en traits pointillés,
- et dans le cas où la structure de support est en silicium massif recouvert d'une couche de nanotubes de carbone d'environ 80 micromètres d'épaisseur et de faible densité (au moins cinq fois plus faible que le carbone massif) : courbe en traits tiretés.

Avec le silicium, les énergies rétrodiffusées peuvent être du même ordre qu'avec le silicium massif, mais ces énergies sont dispersées dans un rayon qui peut être dix fois plus grand que pour le silicium massif, ce qui réduit très significativement l'impact sur le motif global à exposer.

La distance considérée sur la figure 8 est l'éloignement entre le point d'impact du faisceau incident et le point où les électrons rétrodiffusés atteignent la couche électro-sensible. Les courbes portent donc en abscisse un rayon en nanomètres représentant cet éloignement, et en ordonnée, en unités arbitraires, l'énergie des électrons atteignant la couche électrosensible à cette distance.

Enfin, on notera qu'on peut aussi prévoir que le substrat a une épaisseur fortement amincie dans la zone à exposer, de sorte que la partie de substrat susceptible de produire des électrons rétrodiffusés gênants possède une épaisseur beaucoup plus faible que le reste du substrat. Le faisceau d'électrons de haute énergie traverse alors purement et simplement le matériau du substrat recouvert de la couche poreuse, en engendrant une diffusion latérale minime.

## Revendications

1. Structure de support d'une couche de matériau à traiter sélectivement par lithographie par faisceau d'électrons selon un motif de haute résolution, la structure étant destinée à recevoir en outre une couche de masquage électro-sensible (26) pour définir le motif, **caractérisé en ce que** la structure de support comprend la superposition d'un substrat (10), et d'une couche intermédiaire (22) en matériau poreux de densité au moins deux fois plus faible que celle du même matériau non poreux, ce matériau ayant une faible masse atomique, inférieure à 32.

2. Structure de support selon la revendication 1, **ca-**

**ractérisé en ce que** la masse atomique du matériau est inférieure à 20.

3. Structure de support selon la revendication 2, **caractérisé en ce que** la densité est comprise entre 0,1 et 0,5 fois la densité du matériau non poreux.

4. Structure de support selon l'une des revendications 1 à 3, **caractérisée en ce que** la couche poreuse est en silicium poreux ou en nanotubes de carbone.

5. Structure de support selon la revendication 4, caractérisée en que l'épaisseur de la couche intermédiaire est d'au moins 50 micromètres.

6. Structure de support selon l'une des revendications 1 à 5, **caractérisée en ce que** la couche de matériau à traiter est une couche de silicium monocristallin et **en ce que** la structure de support comporte une couche isolante au-dessus de la couche intermédiaire poreuse, la couche de silicium monocristallin étant formée au-dessus de la couche isolante.

7. Structure de support selon l'une des revendications 1 à 5, **caractérisée en ce que** la couche de matériau à traiter est une couche d'un matériau conducteur, isolant ou semiconducteur déposée au-dessus d'une couche de silicium monocristallin, et **en ce que** la structure de support comporte une couche isolante au-dessus de la couche intermédiaire poreuse, la couche de silicium monocristallin étant formée au-dessus de la couche isolante.

8. Structure de support selon l'une des revendications 6 et 7, **caractérisée en ce que** la structure de support est formée par un premier substrat recouvert sur sa face avant de la couche poreuse, et un deuxième substrat reporté contre le premier, le deuxième substrat étant en silicium monocristallin revêtu de la couche isolante et étant aminci à une épaisseur inférieure ou égale à 100 nanomètres.

9. Procédé de lithographie électronique comprenant la formation d'une structure de support comportant un substrat recouvert d'une couche poreuse d'un matériau ayant une densité inférieure à la moitié de la densité du même matériau non poreux et ayant un numéro atomique inférieur à 20, la mise en place au-dessus de la couche poreuse d'une couche mince de matériau à traiter sélectivement selon un motif de haute résolution, la mise en place d'une couche de matériau sensible à un faisceau électronique, et l'exposition de la couche de matériau sensible à un faisceau électronique de haute énergie pour définir le motif dans cette dernière couche, puis une opération de traitement, par implantation et/ou gravure, de la couche de matériau à traiter sélectivement.

**10.** Procédé de lithographie électronique selon la revendication 9, **caractérisé en ce que** le matériau de la couche poreuse est du silicium ou des nanotubes de carbone.

**Patentansprüche**

**1.** Auflagestruktur für eine durch Elektronenstrahllithografie mit einem Hochauflösungsmuster selektiv zu behandelnde Materialschicht, wobei die Struktur zum weiteren Aufnehmen einer elektroempfindlichen Maskierungsschicht (26) zum Definieren des Musters gedacht ist, **dadurch gekennzeichnet, dass** die Auflagestruktur die Übereinanderlage eines Substrats (10) und einer Zwischenschicht (22) aus einem porösen Material mit einer Dichte beinhaltet, die wenigstens zweimal so niedrig ist wie die desselben nicht-porösen Materials, wobei das Material eine niedrige Atommasse von weniger als 32 hat.

**2.** Auflagestruktur nach Anspruch 1, **dadurch gekennzeichnet, dass** die Atommasse des Materials kleiner als 20 ist.

**3.** Auflagestruktur nach Anspruch 2, **dadurch gekennzeichnet, dass** die Dichte etwa das 0,1 bis 0,5fache der Dichte des nicht-porösen Materials beträgt.

**4.** Auflagestruktur nach einem der Ansprüche 1 bis 3, **dadurch gekennzeichnet, dass** die poröse Schicht aus porösem Silicium oder aus Kohlenstoffnanoröhrchen besteht.

**5.** Auflagestruktur nach Anspruch 4, **dadurch gekennzeichnet, dass** die Zwischenschicht eine Dicke von wenigstens 50 Mikrometern hat.

**6.** Auflagestruktur nach einem der Ansprüche 1 bis 5, **dadurch gekennzeichnet, dass** die zu behandelnde Materialschicht eine Schicht aus monokristallinem Silicium ist, und dadurch, dass die Auflagestruktur eine Isolierschicht über der porösen Zwischenschicht umfasst, wobei die Schicht aus monokristallinem Silicium über der Isolierschicht ausgebildet ist.

**7.** Auflagestruktur nach einem der Ansprüche 1 bis 5, **dadurch gekennzeichnet, dass** die zu behandelnde Materialschicht eine Schicht aus einem leitenden, isolierenden oder halbleitenden Material ist, die auf einer Schicht aus monokristallinem Silicium abgesetzt ist, und dadurch, dass die Auflagestruktur eine Isolierschicht über der porösen Zwischenschicht umfasst, wobei die Schicht aus monokristallinem Silicium über der Isolierschicht ausgebildet ist.

**8.** Auflagestruktur nach einem der Ansprüche 6 bis 7, **dadurch gekennzeichnet, dass** die Auflagestruktur durch ein erstes, auf seiner Vorderseite mit der porösen Schicht bedecktes Substrat und ein an das erste Substrat angelegtes zweites Substrat gebildet ist, und wobei das zweite Substrat aus monokristallinem Silicium gebildet ist, das mit der Isolierschicht beschichtet und auf eine Dicke von gleich oder weniger als 100 Nanometer verdünnt ist.

**9.** Elektronisches Lithografieverfahren, das Folgendes beinhaltet: Bilden einer Auflagestruktur, die ein Substrat umfasst, das mit einer porösen Schicht aus einem Material mit einer Dichte von weniger als der Hälfte der Dichte desselben nicht-porösen Materials und mit einer Atommasse von weniger als 20 beschichtet ist, Installieren einer dünnen Schicht aus selektiv mit einem Hochauflösungsmuster zu behandelnden Material über der porösen Schicht, Installieren einer Schicht aus für einen Elektronenstrahl empfindlichem Material und Exponieren der Schicht aus empfindlichem Material gegenüber einem Hochenergie-Elektronenstrahl, um das Muster in dieser Endschicht zu definieren, dann Behandeln der selektiv zu behandelnden Materialschicht durch Implantieren und/oder Ätzen.

**10.** Elektronisches Lithografieverfahren nach Anspruch 9, **dadurch gekennzeichnet, dass** das Material der porösen Schicht Silicium oder Kohlenstoffnanoröhrchen ist.

**Claims**

**1.** A support structure for a layer of material to be selectively treated by electron beam lithography with a high resolution pattern, said structure being intended to further receive an electro-sensitive masking layer (26) for defining said pattern, **characterised in that** said support structure comprises the superposition of a substrate (10) and of an intermediate layer (22) made of a porous material with a density that is at least twice as low as that of the same non-porous material, said material having a low atomic mass of less than 32.

**2.** The support structure according to claim 1, **characterised in that** the atomic mass of said material is less than 20.

**3.** The support structure according to claim 2, **characterised in that** the density is between 0.1 and 0.5 times the density of the non-porous material.

**4.** The support structure according to any one of claims 1 to 3, **characterised in that** said porous layer is made of porous silicon or of carbon nanotubes.

**5.** The support structure according to claim 4, **characterised in that** said intermediate layer is at least 50 micrometres thick.

**6.** The support structure according to any one of claims 1 to 5, **characterised in that** said layer of material to be treated is a layer of monocrystalline silicon and **in that** said support structure comprises an isolating layer above said porous intermediate layer, said layer of monocrystalline silicon being formed above said isolating layer.

**7.** The support structure according to any one of claims 1 to 5, **characterised in that** said layer of material to be treated is a layer of a conducting, isolating or semi-conducting material deposited above a layer of monocrystalline silicon, and **in that** said support structure comprises an isolating layer above said porous intermediate layer, said layer of monocrystalline silicon being formed above said isolating layer.

**8.** The support structure according to any one of claims 6 to 7, **characterised in that** said support structure is formed by a first substrate covered on its front face with said porous layer, and by a second substrate placed against said first substrate, said second substrate being made of monocrystalline silicon coated with said isolating layer and being thinned to a thickness that is less than or equal to 100 nanometres.

**9.** An electronic lithography method comprising the formation of a support structure comprising a substrate coated with a porous layer of a material having a density that is less than half the density of the same non-porous material and having an atomic number that is less than 20, the installation above said porous layer of a thin layer of material to be selectively treated with a high resolution pattern, the installation of a layer of material sensitive to an electron beam and the exposure of said layer of sensitive material to a high-energy electron beam in order to define the pattern in this final layer, then an operation of treating, by implantation and/or etching, the layer of material to be selectively treated.

**10.** The electronic lithography method according to claim 9, **characterised in that** the material of said porous layer is silicon or carbon nanotubes.

EP 2 883 110 B1

5nm 5nm

**Fig. 1**

Th

**Fig. 2**

**Fig. 3**

16    14    12

10

**Fig. 4**

26    24    22

10

**Fig. 5**

Si poreux 80micromètres, densité 20%

Si bulk

Nanotubes de C

Rayon ( nm )

Energie (a.u.)

**Energie des électrons rétrodiffusés**
Faisceau incident 50kV

**Fig. 8**

22

24

26

30

32

10

**Fig. 6**

22

24

26

30

32

10

**Fig. 7**

**EP 2 883 110 B1**

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **EISENMANN H. ; WAAS T. ; HARTMANN H.** PROXECCO - Proximity effect correction by convolution. *Journal of vacuum science and technology B,* Novembre 1993, vol. 11 (6), 2741-2745
- *Japanese journal of Applied Physics,* 1998, vol. 37 (12B), 6774-6778
- **YAMASHITA H.** Proximity effect correction by the GHOST method using a scattering stencil mask. *Journal of vacuum science and technology B,* Novembre 1999, vol. 17 (6), 2860-2863
- Nanometer Patterning by Electron Beam Lithography Using an Amorphous Carbon Film as an Intermediate Layer. *Japanese Journal of Applied Physics,* Avril 1991, vol. 30 (4), 890-891